# EUROPEAN PATENT APPLICATION

(11) **EP 4 521 881 A1**
(43) Date of publication of application: **12.03.2025**
(21) Application number: 24192419.0
(22) Date of filing: 01.08.2024
(51) Int. Cl.: H10D 1/00, H10D 1/66, H01L 23/64, H10D 84/00, H10D 1/68

(54) **CMOS DEVICES FOR HIGH-VOLTAGE APPLICATIONS**

(30) Priority: 07.09.2023 GB 202313648
(71) Applicant: X-FAB Global Services GmbH, 99097 Erfurt (DE); Melexis Technologies NV, 3980 Tessenderlo (BE)
(72) Inventor: LERNER, Ralf, 99085 Erfurt (DE); WEIRAUCH, Robin, 99880 Waltershausen (DE); DE PAUW, Piet, B-9700 Oudenaarde (BE)
(74) Representative: Marks & Clerk LLP

(57) **Abstract**

An integrated device (1) comprises an electrically conductive substrate (7) having an upper surface (9) comprising a recess (11) and a lower surface for contacting the device, a multi-layer stack (19) provided on the upper surface of the substrate and lining the recess, and an electrically conductive layer (5) for contacting the device provided on the multi-layer stack. The multi-layer stack comprises a first (251), a second (252), a third (253) and a fourth (254) dielectric layer. Immediately adjacent dielectric layers have different bandgaps to trap charge carriers at respective interfaces between the dielectric layers during operation of the device.

## Description

### Technical Field

The present disclosure relates to complementary metal oxide semiconductor (CMOS) devices, for example RC snubber devices.

### Background

Complementary metal oxide semiconductor (CMOS) capacitors are used in wide range of applications. For example, a CMOS capacitor may be formed in series with a resistor portion to form a "RC snubber" device, i.e. a resistor-capacitor snubber device (e.g. for integration into electrical power modules). In this case, the device commonly comprises trench structures to increase the effective surface area of the electrodes and thus the capacitance per area. However, the patterned electrodes typically have sharp corners causing a high electric field strength near the corners which in turn limits the operating voltage of the capacitor and respectively the operating voltage of the RC snubber device.

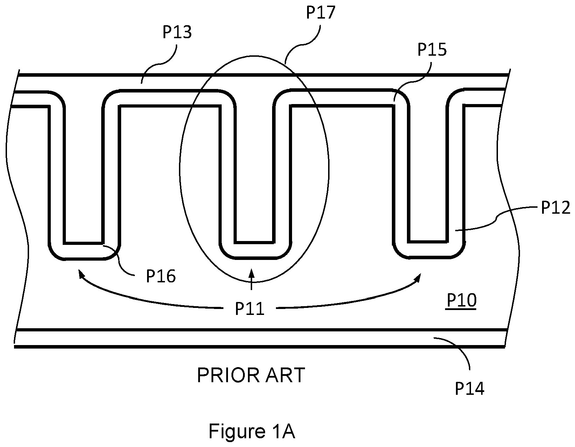

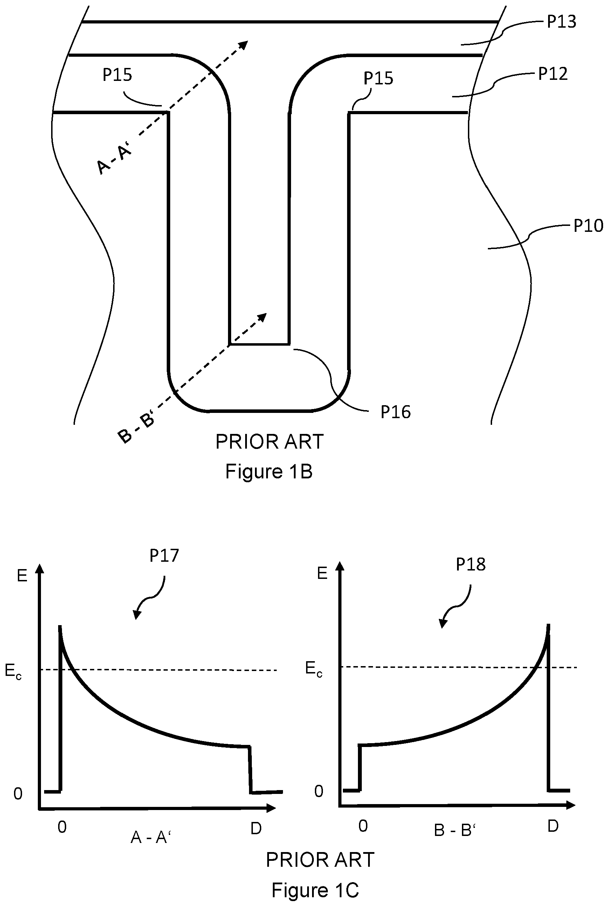

To illustrate this further, a conventional CMOS RC snubber device is described with reference Figures 1A-C (a similar device is also described in US 7738226 B2). The device has a lower metal layer P14 in contact with a doped silicon substrate P10 which determines the resistive portion of the device. The substrate P10 includes a large number of deep trenches P11 etched into an upper surface of the substrate. The trench walls are coated with an insulating layer P12 which determines the capacitive part of the device. The trenches are filled with an electrically conductive material forming an upper electrode P13. A portion of the upper electrode protrudes into the trenches P11. Thus, as further illustrated in Figure 1B (showing area P17 of Figure 1A enlarged), the substrate P10 has sharp corners P15 at the upper surface, and the upper electrode P13 has sharp corners P16 at a lower end of the portion protruding into the trench. As mentioned above, such sharp corners lead to high electric fields during use of the device. Figure 1C shows in graphs P17, P18 the electric field strength inside the insulating layer P12 respectively along the indicated paths A-A' and B-B' when a voltage is applied between the metal layer P14 and the upper electrode P13. Close to the sharp corners P15, P16 the electric field strength is highest and decreases as a function of distance away from the sharp corner. In this example, the electric field strength close to the corner is greater than the critical field strength E_{c} of the device. This means that the electric field enhancement caused by the sharp corners leads to an electric breakdown of the insulating layer P12 and consequently to damage to the device.

### Summary

A problem with conventional complementary metal oxide semiconductor (CMOS) devices that comprise trench capacitors is that the patterned electrodes have sharp corners which limit the operating voltage of the device (because of electric field enhancement effects near the sharp corners). This means that these devices are not suitable for high voltage application. For example, a conventional CMOS RC snubber device with integrated trench capacitor may not be suitable for use in a high-voltage (e.g. 800 V) integrated power module. To at least partly solve this problem, the present invention provides an improved CMOS device and an improved integrated power module such as set out in the accompanying claims.

In overview, the present invention aims to provide new and useful CMOS devices (e.g. capacitors, RC snubber devices and the like). In general, embodiments of the present invention may enable, for example, CMOS devices with a higher breakdown voltage than conventional devices. Embodiments may achieve this by providing an electrically conductive substrate comprising one or more recesses (e.g. pits and/or trenches), a multi-layer stack (e.g. a stack of dielectric layers) provided on the substrate and lining the one or more recesses, and an electrically conductive layer provided on the multi-layer stack. The multi-layer stack may comprise at least four dielectric layers and may be configured to trap charge carriers at respective interfaces between the dielectric layers during operation of the device. The trapped charges may form "effective, rounded electrodes" which reduce the electric field strength near the sharp corners of the electrodes. Thus, embodiments may exhibit a reduced peak electric field strength between the electrodes compared to conventional designs which use a single dielectric layer between the electrodes. Consequently, embodiments of the present invention can be operated at a higher voltage than conventional devices, and may be particularly suitable for high-voltage applications such as high-voltage integrated power modules. Embodiments of the present invention may be manufactured using conventional CMOS processes.

### Brief Description of the Drawings

Embodiments of the invention will now be described, by way of example only, with reference to the accompanying schematic drawings, in which:
Figure 1A is a schematic of a conventional RC snubber device;
Figure 1B is a close-up of portion P17 of the conventional RC snubber device of Figure 1A;
Figure 1C shows two graphs illustrating an electric field strength;
Figure 2 is a schematic of a semiconductor device according to an embodiment;
Figure 3A is a band diagram of a multi-layer stack comprised in the device of Figure 2;
Figure 3B shows the band diagram of Figure 3A when an external voltage is applied; and
Figure 4 is a graph illustrating an electric field strength within the multi-layer stack comprised in the device of Figure 2.

To avoid unnecessary repetition, like reference numerals will be used to denote like features in the figures.

### Detailed Description

According to a first embodiment there is provided an integrated device (also referred to as a "complementary metal oxide semiconductor (CMOS) device" hereafter) (e.g. a capacitor or RC snubber device) comprising an electrically conductive substrate having an upper surface comprising a recess (e.g. a trench or a pit) and a lower surface for contacting the device, a multi-layer stack provided on the upper surface of the substrate and lining the recess and an electrically conductive layer for contacting the device provided on the multi-layer stack. The multi-layer stack comprises a first, a second, a third and a fourth dielectric layer. Immediately adjacent dielectric layers have different bandgaps to trap charge carriers at respective interfaces between the dielectric layers during operation of the device.

By trapping charges at interfaces between the dielectric layers, "effective electrodes" are formed which mitigate any electric field enhancements caused by sharp corners or sharp edges of the recess or the electrically conductive layer provided on the multi-layer stack. This enables CMOS devices with higher breakdown voltages which can be manufactured with conventional methods (i.e. the recess and the electrically conductive layer provided on the multi-layer stack can be formed in a conventional way that may result in sharp corner or edges).

The electrically conductive substrate may be a semiconductor substrate comprising a doped region, the doped region extending from the lower surface of the substrate to the upper surface of the substrate, and may have a predetermined electrical conductivity. In some implementations, the electrically conductive substrate may be a semiconductor substrate doped to have a predetermined electrical conductivity.

Each dielectric layer may have a respective bandgap. The first dielectric layer may be provided on the upper surface of the substrate. The second dielectric layer may be provided on the first dielectric layer. The third dielectric layer may be provided on the second dielectric layer. The fourth dielectric layer may be provided on the third dielectric layer. The bandgaps of immediately adjacent dielectric layers may be different. In this case, the first and the third dielectric layer may comprise a first dielectric material, and the second and the fourth dielectric layer may comprise a second dielectric material.

The first dielectric material may comprise an oxide (e.g. silicon oxide). For example, the first dielectric layer may be a thermally grown silicon oxide layer.

The second dielectric material may comprise silicon nitride.

The first and the second dielectric layer may have the same thickness. The third and the fourth dielectric layer may have the same thickness. The first and the second dielectric layer may have a first thickness, and the third and fourth dielectric layer have a second thickness different from the first thickness.

The second thickness may greater than the first thickness. The second thickness may be twice the first thickness.

A breakdown voltage of the device may be equal to or larger than 800 V, preferably equal to or larger than 1200 V.

The upper surface of the electrically conductive substrate may comprise a plurality of recesses, and the multi-layer stack may line each of the recesses.

The multi-layer stack may comprise further dielectric layers.

A thickness of the multi-layer stack may be equal or greater than 1 µm. A thickness of each dielectric layer of the multi-layer stack may be equal or greater than 100 nm.

The device may be manufacturable using (conventional) CMOS processing techniques.

In some implementations, the integrated device comprises a polar capacitor which comprises the electrically conductive substrate, the multi-layer stack and the electrically conductive layer. In some these implementations, the integrated device may be an integrated snubber circuit and may further comprise an electrode provided on the lower surface of the substrate. The electrode and the substrate may collectively form a resistive portion of the snubber circuit (electrically connected in series with the capacitor).

According to a second embodiment there is provided an integrated power module comprising the CMOS device of the first aspect and a transistor for controlling an electrical current through a load, the transistor being connected in parallel with the CMOS device.

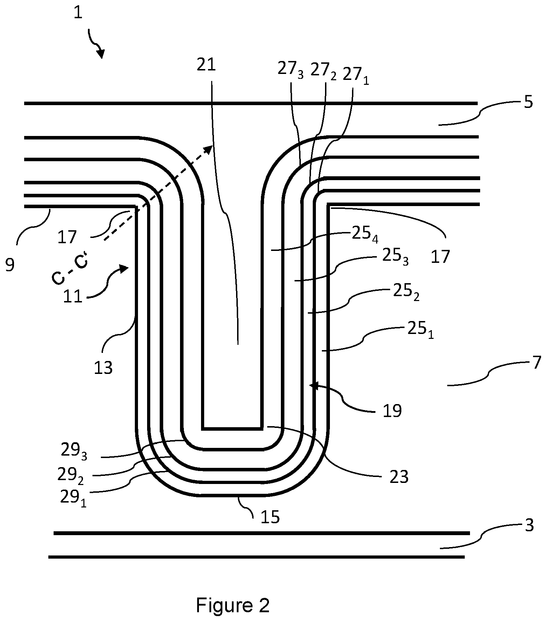

In broad terms, a high-voltage integrated circuit (or "integrated device") is proposed that can be formed with standard complementary metal oxide semiconductor (CMOS) manufacturing processes (thus the integrated circuit is referred to as a CMOS device or a CMOS component hereafter). The proposed CMOS device may comprise a (trench) capacitor portion. In the proposed CMOS device, a stack of dielectric layers ("multi-layer stack" hereafter) is provided between the electrodes of the (trench) capacitor portion. As described in detail below with reference to Figures 2 to 4, a purpose of the multi-layer stack is to increase the breakdown voltage of the capacitor portion by trapping charges at the interfaces of the dielectric layers.

Figure 2 shows a schematic cross-section of a CMOS device 1 according to an embodiment. In general, the CMOS device 1 comprises a capacitor portion electrically connected in series with a resistive portion to form a "RC snubber" device. More specifically, the device 1 may comprise a first (or lower) electrode 3 and a second (or upper) electrode 5 for contacting the device 1. The lower and the upper electrode 3, 5 may each comprise a metal layer. The lower electrode 3 may be an anode of the CMOS device 1, and the upper electrode 5 may be a cathode of the CMOS device 1. In other words, the CMOS device 1 may be operated with a fixed polarity, i.e. during operation of the CMOS device 1, a potential applied to the lower electrodes 3 may be equal to or greater than a potential applied to the upper electrode 5. For example, the upper electrode 5 may be electrically connected to ground.

The lower electrode 3 may be provided on a lower surface of an electrically conductive substrate 7. The substrate 7 may be a doped semiconductor substrate (e.g. silicon). For example, the substrate 7 may be a semiconductor substrate doped such that (i.e. doped with appropriately selected doping polarity, doping concentration and the like) substrate 7 has a predetermined electrical conductivity.

The substrate 7 has an upper surface 9 comprising at least one recess 11. While only one recess 11 is shown in Figure 2, it is understood that the substrate 7 typically comprises a (large) plurality of (substantially identical) recesses. In general, the recess 11 may extend from the upper surface 9 in a vertically downward direction. The recess 11 may have a sidewall 13 and a bottom surface 15. The sidewall 13 of the recess 11 may form a sharp corner 17 (or sharp edge) with a portion of the upper surface 9 of the substrate 7. For example, an upper portion of the sidewall 13 may be in direct contact with a (substantially) orthogonal portion of the upper surface 9.

The recess 11 may have any suitable shape, e.g. the recess 11 may have a trench or a cylindrical shape. In any case, as shown in Figure 2, the recess 11 may be deep and narrow, i.e., the recess 11 may have a high aspect ratio (e.g. a depth to width ratio of greater than 10 or greater than 20). A width of the recess 11 may be equal to or greater than 0.5 µm. For example, the width of the recess 11 may in the range between 0.5 µm and 20 µm. In any case, the width of the recess 11 may be larger than twice the thickness of multi-layer stack 19 described below. A depth of the recess 11 may be equal to or greater than 5 µm. For example, the depth of the recess 11 may in the range between 5 µm and 200 µm. The recess 11 may be formed using any known suitable method (e.g. reactive ion etching).

The multi-layer stack 19 is provided on the upper surface 9 of the substrate 7. In particular, the multi-layer stack 19 may line the recess 11, i.e. a first surface of the multi-layer stack 19 may be in contact with the sidewall 11 and the bottom surface of the recess 11. The multi-layer stack 19 may comprise four dielectric layers, which are described in detail below. In general, on the sidewall 11 of the recess 11, the multi-layer stack 19 may have a (total) layer thickness that is equal or greater than 1 µm. For example, the layer thickness of the multi-layer stack 19 on the sidewall 11 may be in a range between 1 µm and 3 µm. In embodiments, the multi-layer stack 19 may have a substantially uniform thickness (as shown in the schematic cross-section of Figure 2). In other embodiments, the thickness of the multi-layer stack 19 may not be uniform, e.g. the layer thickness of the multi-layer stack 19 on the (vertical) sidewall 11 may be different (e.g. smaller) than on horizontal portions of the upper surface 9, for example due to a manufacturing process.

The upper electrode 5 is provided on the multi-layer stack 19, i.e. a second surface of the multi-layer stack 19 may be in contact with the upper electrode 5. As shown in Figure 2, the upper electrode 5 may coat the multi-layer stack 19 and fill the recess 11. Thus, the upper electrode 5 may comprise a portion 21 that extends into the recess. At a lower end of the portion 21, the electrode may comprise a sharp corner 23 (or a sharp edge). Thus, both the substrate 7 and the upper electrode 5 may comprise sharp corners 17 and 23. As described below, problematic electric field peaks that are associated with these sharp corners 17, 23 are mitigated by the multi-layer stack 19.

The multi-layer stack 19 comprises a first, a second, a third and a fourth dielectric layer 25₁, 25₂, 25₃, 25₄. As shown in Figure 2, the first dielectric layer 25, may be provided on (i.e. may be in contact with) the upper surface of the substrate 9. The second dielectric layer 25₂ may be provided on (i.e. may be in contact with) the first dielectric layer 25₁. The third dielectric layer 25₃ may be provided on (i.e. may be in contact with) the second dielectric layer 25₂. The fourth dielectric layer 25₄ may be provided on (i.e. may be in contact with) the third dielectric layer 25₃. The upper electrode 5 may be provided on (i.e. may be in contact with) the fourth dielectric layer 25₄.

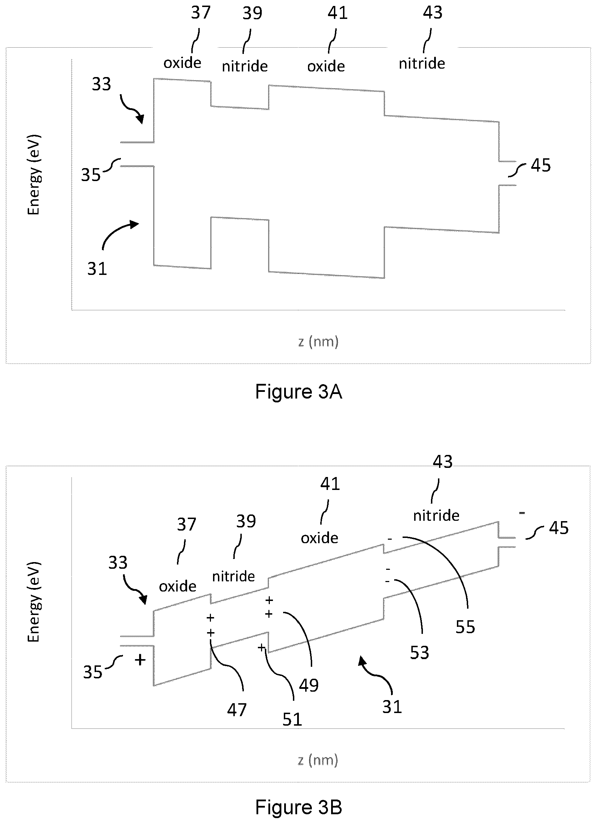

In general, the dielectric layers 25₁ to 25₄ are configured to trap charge carriers at respective interfaces between the dielectric layers during operation of the device, as described below with reference to Figures 3A and 3B. This may be achieved by appropriately selecting bandgaps and thicknesses of the dielectric layers 25₁ to 25₄ as described below. More specifically, each of the dielectric layers 25₁ to 25₄ has a respective bandgap (typically greater than 2 eV), and the dielectric layers 25₁ to 25₄ are selected such that the bandgaps of immediately adjacent dielectric layers are different (e.g. the first dielectric layer 25, may have a different bandgap than the second dielectric layer 25₂, the second dielectric layer 25₂ may have a different bandgap than the third dielectric layer 25₃, and so on). To this end, immediately adjacent dielectric layers may be formed of different materials (silicon oxide, silicon nitride, or any other suitable CMOS compatible dielectric material).

In broad terms, trapping of charge carrier at the interface of dielectric layers (having different bandgaps) may occur for a number or reasons. For example, it is known that when dielectric layers are placed between two electrodes and an external voltage is applied, charge carriers may (temporarily) be trapped at the interface of the dielectric layers due to the changes in the bandgap at the interface. It is also known that trapping of charge carriers can occur due to (lattice) defects which (inevitably) occur at the boundary between two different dielectric materials.

In the embodiment of Figure 2, the first and the third dielectric layer 25₁, 25₃ comprise a first dielectric material, and the second and the fourth dielectric layer comprise a second dielectric material. Using (only) two dielectric materials to form the layers of the multi-layer stack 19 may result in a simple manufacturing process of the device 1. However, it is understood that in other embodiments, more than two dielectric materials are used to form the multi-layer stack 19 (e.g. each of the dielectric layer 25₁ to 25₄ may comprise a different dielectric material).

More specifically, in the embodiment of Figure 2, the first dielectric material may comprise an oxide (e.g. silicon oxide), i.e. the first dielectric layer 25, and the third dielectric layer 25₃ may comprise the oxide. For example, the oxide of the first dielectric layer 25, may comprise a thermal oxide formed by thermal oxidation of the substrate 7, and the oxide of the third dielectric layer 25₃ may be formed by any suitable and known deposition process (such as chemical vapor deposition (CVD)). In embodiments, it may be advantageous for first dielectric layer 25, to comprise a thermal oxide since the thermal oxide may consume substrate material during the respective production process and thereby may reduce damage (produced, for example, by preceding production process such as plasma etching) and may smoothen a surface roughness of the recess 11.

Further, the second dielectric material may comprise silicon nitride, i.e. the second dielectric layer 25₂ and the fourth dielectric layer 25₄ may comprise silicon nitride.

In general, the interfaces between dielectric layers 25₁ to 25₄ may comprise rounded corners, in particular rounded corners 27₁, 27₂, 27₃ near the top end of the recess 11 (i.e. covering the sharp corner 17 of the substrate 7), and rounded corners 29₁, 29₂, 29₃ near the bottom end of the recess 11 (i.e. covering the sharp corner 23 of the upper electrode 5). In this case, since, during operation of the device 1, charge carriers are trapped at the interfaces between dielectric layers 25₁ to 25₄ (as described below with reference to Figure 3) and the interfaces comprise rounded corners covering the sharp corners of the substrate 7 and the upper electrode 5, the electric field peaks near the sharp corners may be strongly reduced and the breakdown voltage of the device may be increased.

A radius of curvature of the rounded corners 27₁, 27₂, 27₃, 29₁, 29₂, 29₃ may be determined by the layer thickness of the dielectric layers beneath the respective interface. For example, the radius of curvature of the rounded corners 27, of the interface between the first and the second dielectric layers 25₁, 25₂, may be determined by the layer thickness of the first dielectric layer 25₁. As another example, the radius of curvature of the rounded corners 27₂ of the interface between the second and the third dielectric layers 25₂, 25₃, may be determined by the layer thicknesses of the first dielectric layer 25, and the second dielectric layer 25₂. As further example, the radius of curvature of the rounded corners 27₃ of the interface between the third and the fourth dielectric layers 25₃, 25₄, may be determined by the layer thicknesses of the first dielectric layer 25₁, the second dielectric layer 25₂ and the third dielectric layer 25₃.

The first and the second dielectric layer 25₁, 25₂ may have (substantially) the same thickness. Further, the third and the fourth dielectric layer 25₃, 25₄ have (substantially) the same thickness which may be different from (e.g. larger than) the thickness of the first and the second dielectric layer 25₁, 25₂. More specifically, in the embodiment of Figure 2, the thickness of the third and the fourth dielectric layer 25₃, 25₄ may be twice the thickness of first and the second dielectric layer 25₁, 25₂. In other words, in the embodiment of Figure 2, the thickness of the each of the first and second dielectric layer 25₁, 25₂ is about 1/6 of the total thickness of the multi-layer stack 19, and the thickness of the each of the third and fourth dielectric layer 25₃, 25₄ is about 1/3 of the total thickness of the multi-layer stack 19. However, it will be apparent to one skilled in the art that this is not a stringent requirement, e.g. each of the thicknesses of the first to fourth dielectric layer 25₁ to 25₄ may be different. In any case, the thickness of each dielectric layer 25₁ to 25₄ of the multi-layer stack 19 may be equal or greater than 100 nm.

The trapping of charge carries during operation of the device 1 is described with reference to Figures 3A and 3B. Figure 3A shows a band diagram of a valence band 31 and a conduction band 33 along a cross-section between the substrate 7 and the upper electrode 5 (when no voltage is applied across the lower and upper electrodes 3, 5). The reference numbers 35, 37, 39, 41, 43 and 45 respectively indicate the valence and conduction band of the substrate 7, the first to fourth dielectric layer 25₁ to 25₄ and the upper electrode 5. As shown in Figure 3A, the bandgap of the dielectric layer 25₁ to 25₄ is substantially larger than the bandgap of the substrate 7 and the upper electrode 5. As further indicated in Figure 3A, the bandgap of the oxide layers is larger than the bandgap of the nitride layers (e.g. thermal silicon oxide may have a bandgap between 8 and 11 eV, and silicon nitride may have bandgap between 4 and 6 eV).

Figure 3B shows the band diagram of Figure 3A when a positive voltage is applied to the lower electrode 3 and the upper electrode 5 is connected to ground, i.e. during operation of the device 1. Figure 3B shows that positive charge carriers 47 (indicated by the "+" symbol) are trapped at the interface of the first and the second dielectric layers 25₁, 25₂. These charges may be trapped in states between the valence and conduction bands 31, 33 caused by crystal defects at the interface. The charge carries 47 may be predominantly positive charge carriers since the interface of the first and the second dielectric layers 25₁, 25₂ is closer to the substrate 7 (anode) than the upper electrode 5 (cathode). Similarly, positive charge carriers 49 are trapped in states between the valence and conduction bands 31, 33 at the interface of the second and the third dielectric layers 25₂, 25₃. Further, because the third dielectric layer 25₃ has a larger bandgap than the second dielectric layers 25₂ (in particular, near the interface, the valence band of the third dielectric layers 25₃ is lower than the valence band of the second dielectric layers 25₂), the discontinuity of the valence band forms a potential barrier for positive charges and, as a consequence, additional positive charge carriers 51 are trapped at the interface of the second and the third dielectric layers 25₂, 25₃.

Further, negative charge carriers 53 (indicated by the "-" symbol) are trapped in states between the valence and conduction bands 31, 33 at the interface of the third and the fourth dielectric layers 25₃, 25₄. The charge carries 53 may be predominantly negative charge carriers since the interface of the third and the fourth dielectric layers 25₃, 25₄ is closer to the upper electrode 5 (cathode) than the substrate 7 (anode). Further, because the fourth dielectric layer 25₄ has a smaller bandgap than the third dielectric layers 25₂ (in particular, near the interface, the conduction band of the fourth dielectric layers 25₄ is lower than the conduction band of the third dielectric layers 25₃), the discontinuity of the conduction band forms a potential barrier for negative charge carries, and, as a consequence, additional negative charge carriers 55 are trapped at the interface of the third and the fourth dielectric layers 25₃, 25₄.

In broad terms, the trapped charges 47, 49, 51, 53, 55 at the interfaces of the dielectric layers 25₁ to 25₄ reduce the strong peak electric fields produced by the sharp corners, in particular because the interfaces of the dielectric layers 25₁ to 25₄ comprise rounded corners (as described above). Thus, in simplified terms, the interfaces of dielectric layers 25₁ to 25₄ can be considered to form "effective" rounded electrodes mitigating the field enhancement effects of the sharp corners of the substrate 7 and the upper electrode 5. Thus, since the radius of curvature of the interfaces is determined by the layer thicknesses of the dielectric layers 25₁ to 25₄, the layer thicknesses of the dielectric layers 25₁ to 25₄ may be selected to optimise the radius of the "effective" electrodes while avoiding, for example, detrimental tunnelling effects between the dielectric layers 25₁ to 25₄.

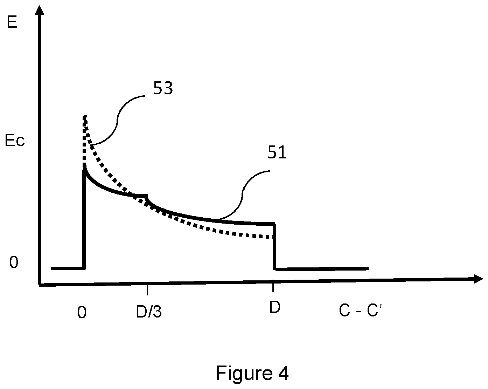

Figure 4 shows a graph that illustrates the electric field 51 along the "C-C'" cross-section of Figure 2 together with the electric field 53 along the "A-A"' cross-section of the conventional RC snubber of Figure 1B. Figure 4 shows that the peak electric field is reduced for the proposed device (because of the charge trapping as described above). Thus, the breakdown voltage of the device may be increased compared to the conventional device of Figure 1A. The graph 51 is not based on a computational simulation of the above described device 1 (such a simulation is considered to result in a more complex but broadly equivalent electric field distribution) but is provided to ease the understanding of the effect of the above described multi-layer stack 19.

While the embodiment of Figure 2 comprises a multi-layer stack comprising four dielectric layers, it will be apparent to one skilled in the art that embodiments may comprise more than four dielectric layers.

While the embodiment of Figure 2 is a RC snubber device, it will be apparent to one skilled in the art that embodiments include other CMOS devices that may employ the described multi-layer stack to increase the breakdown (and operating) voltage of the respective device. For example, the described multi-layer stack may be used in a (high-voltage) CMOS capacitor. In this case, the substrate 7 may not be a semiconductor substrate but, for example, a metal. As another example, the described multi-layer stack may be used as effective gate dielectric (i.e. as effective dielectric between a gate and a substrate of a field-effect transistor). In this case, the dimensions of the device may be smaller, for example the depth of the recesses may only be approximately 0.5 µm.

While specific embodiments of the invention have been described above, it will be appreciated that the invention may be practiced otherwise than as described. The descriptions above are intended to be illustrative, not limiting. It will be apparent to one skilled in the art that modifications may be made to the invention as described without departing from the scope of the claims set out below.

Each feature disclosed or illustrated in the present specification may be incorporated in the invention, whether alone or in any appropriate combination with any other feature disclosed or illustrated herein.

## Claims

1. An integrated device comprising:
an electrically conductive substrate having an upper surface comprising a recess and a lower surface;
a multi-layer stack provided on the upper surface of the substrate and lining the recess; and
an electrically conductive layer provided on the multi-layer stack;
wherein the multi-layer stack comprises a first, a second, a third and a fourth dielectric layer, immediately adjacent dielectric layers having different bandgaps to trap charge carriers at respective interfaces between the dielectric layers during operation of the device.

2. The integrated device of claim 1, wherein the electrically conductive substrate is a semiconductor substrate comprising a doped region, the doped region extending from the lower surface of the substrate to the upper surface of the substrate, and wherein said substrate has a predetermined electrical conductivity.

3. The integrated device of any preceding claim, wherein
the first dielectric layer is provided on the upper surface of the substrate,
the second dielectric layer is provided on the first dielectric layer,
the third dielectric layer is provided on the second dielectric layer,
the fourth dielectric layer is provided on the third dielectric layer, and
the first and the third dielectric layer comprise a first dielectric material, and the second and the fourth dielectric layer comprise a second dielectric material.

4. The integrated device of claim 3, wherein the first dielectric material comprises an oxide, and optionally wherein the oxide is silicon oxide.

5. The integrated device of any preceding claim, wherein first dielectric layer is a thermally grown silicon oxide layer.

6. The integrated device of any preceding claim, wherein the second dielectric material comprises silicon nitride.

7. The integrated device of any preceding claim, wherein the first and the second dielectric layer have the same thickness, and/or wherein the third and the fourth dielectric layer have the same thickness.

8. The integrated device of any preceding claim, wherein the first and the second dielectric layer have a first thickness, and the third and fourth dielectric layer have a second thickness different from the first thickness,
and optionally wherein the second thickness is greater than the first thickness,
and/or wherein the second thickness is twice the first thickness.

9. The integrated device of any preceding claim, wherein a breakdown voltage of the device is equal to or larger than 800 V, or equal to or larger than 1200 V.

10. The integrated device of any preceding claim, wherein the recess is a trench or has a cylindrical shape,
and/or wherein the upper surface of the electrically conductive substrate comprises a plurality of recesses, and the multi-layer stack lines each of the recesses.

11. The integrated device of any preceding claim, wherein the multi-layer stack comprises further dielectric layers.

12. The integrated device of any preceding claim, wherein a thickness of the multi-layer stack is equal or greater than 1 µm,
and optionally wherein a thickness of each dielectric layer of the multi-layer stack is equal or greater than 100 nm.

13. The integrated device of any preceding claim, wherein the device is manufacturable using complementary metal oxide semiconductor (CMOS) processing techniques.

14. The integrated device of any preceding claim, wherein the integrated device comprises a polar capacitor comprising the electrically conductive substrate, the multi-layer stack and the electrically conductive layer.

15. The integrated device of claim 14, wherein the integrated device is an integrated snubber circuit and further comprises an electrode provided on the lower surface of the substrate, and wherein the electrode and the substrate collectively form a resistive portion of the snubber circuit.
